# EUROPEAN PATENT APPLICATION

(11) **EP 4 576 994 A1**
(43) Date of publication of application: **25.06.2025**
(21) Application number: 24195749.7
(22) Date of filing: 21.08.2024
(51) Int. Cl.: H10D 30/66, H10D 62/10, H10D 62/13, H10D 64/27

(54) **POWER SEMICONDUCTOR DEVICES**

(30) Priority: 20.12.2023 KR 20230187391
(71) Applicant: Samsung Electronics Co., Ltd., Gyeonggi-do, 16677 (KR)
(72) Inventor: KO, Mingu, 16677 Suwon-si (KR); KIM, Youngcheol, 16677 Suwon-si (KR); KIM, Jongseob, Suwon-si (KR); KIM, Taehun, 16677 Suwon-si (KR); PARK, Gyeongseon, 16677 Suwon-si (KR); CHO, Doohyung, Suwon-si (KR)
(74) Representative: Marks & Clerk LLP

(57) **Abstract**

A power semiconductor device includes a substrate having a first conductivity-type. A drift layer is on the substrate and has the first conductivity-type. A well region is on the drift layer and has a second conductivity-type. A source region is on the well region and has the first conductivity-type. A gate electrode is in a gate trench penetrating the source region and the well region. A gate insulating layer is between the gate electrode and the well region. A drain electrode is on a lower surface of the substrate. A lower surface of the gate electrode has a first width and an upper surface has a second width greater than the first width. A side surface of the gate electrode has a step portion where a width of the gate electrode changes. The step portion is positioned at a lower level than a lower surface of the source region.

## Description

### 1. TECHNICAL FIELD

The present inventive concept relates to a power semiconductor device, and to a metal oxide semiconductor field effect transistor (MOSFET) power semiconductor device.

### 2. DISCUSSION OF RELATED ART

Power semiconductor devices are semiconductor devices that operate in high voltage and high current environments. Power semiconductor devices may be used in fields that require high power switching, such as power conversion, power converters, inverters, or the like. Power semiconductor devices should have voltage resistance characteristics against high voltages. Recently, power semiconductor devices may also perform high-speed switching operations. Accordingly, research concerning power semiconductor devices using SiC, which has superior voltage resistance characteristics, as compared to silicon (Si), is being conducted.

### SUMMARY

An aspect of embodiments of the present inventive concept is to provide a power semiconductor device having increased electrical characteristics.

According to embodiment of the present inventive concept, a power semiconductor device includes a substrate having a first conductivity-type. A drift layer is on the substrate. The drift layer has the first conductivity-type. A well region is on the drift layer. The well region has a second conductivity-type. A source region is on the well region. The source region has the first conductivity-type. A gate electrode is in a gate trench penetrating the source region and the well region. A gate insulating layer is between the gate electrode and the well region. A dielectric layer is on the gate electrode. A drain electrode is on a lower surface of the substrate. A lower surface of the gate electrode has a first width. An upper surface of the gate electrode has a second width that is greater than the first width. A side surface of the gate electrode has a step portion where a width of the gate electrode changes. The step portion is positioned at a level lower than a level of a lower surface of the source region.

According to an embodiment of the present inventive concept, a power semiconductor device includes a substrate having a first conductivity-type. A drift layer is on the substrate. The drift layer has the first conductivity-type. A well region is on the drift layer. The well region has a second conductivity-type. A source region is on the well region. The source region has the first conductivity-type. A gate electrode is in a gate trench penetrating the source region and the well region. A gate insulating layer is between the gate electrode and the well region. A drain electrode is on a lower surface of the substrate. The gate electrode includes a first region having a first width that is a maximum width of the first region, and a second region on the first region. The second region has a second width greater than the first width. The well region includes a channel region adjacent to the gate electrode. The channel region includes a region overlapping the first region in a horizontal direction and overlapping the second region in a vertical direction.

According to an embodiment of the present inventive concept, a power semiconductor device includes a substrate having a first conductivity-type. A drift layer is on the substrate. The drift layer has the first conductivity-type. A well region is on the drift layer. The well region has a second conductivity-type. A source region is on the well region. The source region has the first conductivity-type. A gate electrode is in a gate trench penetrating the source region and the well region. A gate insulating layer covers an internal surface of the gate trench. A field relief region covers a portion of an external surface of the gate insulating layer. The field relief region has the second conductivity-type. A drain electrode is on a lower surface of the substrate. An upper surface of the gate electrode has a maximum width and the gate electrode has a vertically asymmetrical shape. The well region includes a region facing the gate electrode that has a bent shape.

At least some of the above and other features of the invention are set out in the claims.

### BRIEF DESCRIPTION OF DRAWINGS

The above and other aspects, features, and advantages of embodiments of the present inventive concept will be more clearly understood from the following detailed description, taken in conjunction with the accompanying drawings, in which:
FIGS. 1A and 1B are a cross-sectional view and a partially enlarged view illustrating a power semiconductor device according to example embodiments.
FIGS. 2A to 2C are cross-sectional views illustrating power semiconductor devices according to example embodiments.
FIGS. 3A and 3B are a cross-sectional view and a partially enlarged view illustrating a power semiconductor device according to example embodiments.
FIGS. 4A and 4B are cross-sectional views illustrating power semiconductor devices according to example embodiments.
FIG. 5 is a cross-sectional view illustrating a power semiconductor device according to an example embodiment.
FIGS. 6A to 6H are views illustrating a process sequence illustrating a method of manufacturing a power semiconductor device according to example embodiments.
FIGS. 7A to 7G are views illustrating a process sequence illustrating a method of manufacturing a power semiconductor device according to example embodiments.
FIGS. 8A to 8I are views illustrating a process sequence illustrating a method of manufacturing a power semiconductor device according to example embodiments.

### DETAILED DESCRIPTION OF EMBODIMENTS

Hereinafter, embodiments of the present inventive concept will be described with reference to the accompanying drawings. Hereinafter, it can be understood that terms such as 'on,' 'upper,' 'upper portion,' `upper surface,' 'below,' 'lower,' `lower portion,' `lower surface,' `side surface,' and the like may be denoted by reference numerals and refer to the drawings, except where otherwise indicated. Relative terms, such as "above", "below", etc. are relative to the structure of the semiconductor device (e.g. based on a vertical axis defined perpendicular to a substrate of the semiconductor device) and therefore do not imply any particular orientation of the semiconductor device in use. As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of a plurality of elements forming the semiconductor device. Accordingly, where the structure of a single element of a plurality of elements has been described, this structure may equally apply to other elements of the plurality of elements.

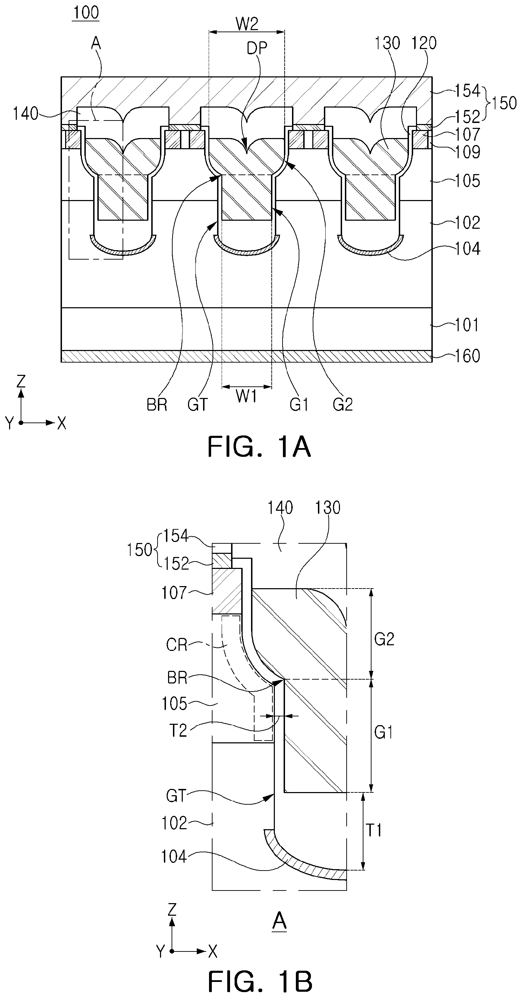

FIGS. 1A and 1B are a cross-sectional view and a partially enlarged view illustrating a power semiconductor device according to example embodiments. FIG. 1B illustrates an enlarged view of portion 'A' of FIG. 1A.

Referring to FIGS. 1A and 1B, in an embodiment a power semiconductor device 100 may include a substrate 101, a drift layer 102 on the substrate 101, well regions 105 disposed on the drift layer 102, source regions 107 disposed on the well regions 105, well contact regions 109 on one side of the source regions 107, gate electrodes 130 disposed in gate trenches GT penetrating the source regions 107 and the well regions 105, gate insulating layers 120 between the gate electrodes 130 and the well regions 105, field relief regions 104 outside the gate trenches GT, dielectric layers 140 covering the gate electrodes 130, a source electrode 150 on the dielectric layers 140, and a drain electrode 160 on a lower surface of the substrate 101.

In an embodiment, the substrate 101 may have an upper surface extending in the X and Y directions (e.g. horizontal directions/a horizontal plane). A vertical direction may be defined perpendicular to the upper surface of the substrate 101 (e.g. perpendicular to the X and Y directions). The terms "horizontal" and "vertical" are relative to the structure of the semiconductor device and do not necessarily limit the semiconductor device to a particular orientation in use. In an embodiment, the substrate 101 may include a semiconductor material, and may include, for example, SiC. However, embodiments of the present inventive concept are not necessarily limited thereto. For example, in some embodiments, the substrate 101 may include a group IV semiconductor material such as Si or Ge, or a compound semiconductor material such as SiGe, GaAs, InAs, or InP.

The substrate 101 may be provided as a bulk wafer or an epitaxial layer. The substrate 101 may include first conductivity-type impurities, and thus may have a first conductivity-type. In some embodiments, the first conductivity-type may be, for example, an N-type, and the first conductivity-type impurities may be N-type impurities such as nitrogen (N) and/or phosphorus (P). In some embodiments, the first conductivity type may be, for example, a P-type, and the first conductivity type impurities may be, for example, P-type impurities such as aluminum (Al).

The drift layer 102 may be disposed on the substrate 101 (e.g., disposed directly thereon in the Z direction). The drift layer 102 may include a semiconductor material, and may include, for example, SiC. In an embodiment, the drift layer 102 may be an epitaxial layer grown on the substrate 101. The drift layer 102 may include first conductivity-type impurities, and thus may have a first conductivity-type. A concentration of the first conductivity-type impurities in the drift layer 102 may be lower than a concentration of the first conductivity-type impurities in the substrate 101. In an embodiment, the first conductivity-type impurities in the substrate 101 and the drift layer 102 may include the same or different elements from each other.

The well regions 105 may be disposed at a predetermined depth from an upper surface of the drift layer 102. In an embodiment, the well regions 105 may be disposed directly on the upper surface of the drift layer 102. The well regions 105 may be disposed to be spaced apart from each other by the gate trenches GT in a horizontal direction, for example, in the X direction. In an embodiment, the well region 105 may include a semiconductor material, and may include, for example, SiC. The well region 105 may be a region having a second conductivity-type, and may include second conductivity-type impurities. For example, the second conductivity-type may be a P-type, and the second conductivity-type impurities may be P-type impurities such as aluminum (Al). In some embodiments, the well region 105 may include a plurality of regions having different doping concentrations.

The well contact regions 109 may be disposed on (e.g., disposed directly thereon in the Z direction) the well regions 105 between adjacent source regions 107. The well contact region 109 may be disposed between the well region 105 and the source electrode 150. The well contact region 109 may allow a voltage from the source electrode 150 to be applied to the well region 105. The well contact region 109 may include a semiconductor material, and may include, for example, SiC. The well contact region 109 may be a region having the second conductivity-type, and may include the second conductivity-type impurities described above. In an embodiment, a concentration of second conductivity-type impurities in the well contact region 109 may be higher than a concentration of second conductivity-type impurities in the well region 105. In example embodiments, a position, a positional period (e.g. spacing), and the like, of the well contact regions 109 may be varied. For example, in some example embodiments, the well contact region 109 may not be disposed between a portion of the source regions 107.

Field relief regions 104 may be disposed along external surfaces of the gate trenches GT, and may cover a portion of the external surfaces thereof. The field relief region 104 may extend along the gate trench GT on a bottom surface of the gate trench GT and in a region adjacent thereto. The field relief region 104 may be located within the drift layer 102 below the gate electrode 130, and may be located between (e.g., directly therebetween) the gate insulating layer 120 and the drift layer 102.

In an embodiment, the field relief region 104 may include a semiconductor material, for example, SiC. The field relief region 104 may be a doped region formed by doping a portion of the drift layer 102. The field relief region 104 may be a region having the same conductivity-type as the well region 105, for example, the second conductivity-type, and may include second conductivity-type impurities. In an embodiment, a concentration of the second conductivity-type impurities in the field relief region 104 may be higher than a concentration of the second conductivity-type impurities in the well region 105. By the field relief region 104, an electric field formed in the drift layer 102 by the gate electrode 130 may be relieved, and thus, breakdown of the gate insulating layer 120 may be prevented.

The source regions 107 may be disposed at a predetermined depth from the upper surfaces of the well regions 105. In an embodiment, a thickness of the source region 107 may be less than a thickness of the well region 105. The source region 107 may include a semiconductor material, and may include, for example, SiC. The source region 107 may be a region having the first conductivity-type, and may include the first conductivity-type impurities described above. In an embodiment, a concentration of the first conductivity-type impurities in the source region 107 may be higher than a concentration of first conductivity-type impurities in the drift layer 102. However, embodiments of the present inventive concept are not necessarily limited thereto.

In an embodiment, the gate trenches GT may extend from the upper surfaces of the source regions 107 through the source regions 107 and the well regions 105 into the drift layer 102. The gate trench GT may penetrate the well regions 105 (e.g., in the Z direction), and a lower end of the gate trench GT may be located within the drift layer 102. However, a length of the gate trench GT extending into the drift layer 102 may vary in various example embodiments. For example, in some example embodiments, the lower end of the gate trench GT may also be located on the upper surface of the drift layer 102 and may not penetrate the drift layer 102 (e.g., in the Z direction).

In an embodiment, the gate trench GT may have a step portion having a varying width (e.g., as measured in the X direction) discontinuously, corresponding to the step portion BR of the gate electrode 130, and thus a width (e.g., as measured in the X direction) of the upper region may be greater than a width of the lower region. The step portion may be located within the well region 105. The gate trench GT may include a region having a width that non-linearly increases upwardly from the step portion, and may include a region having a substantially constant width while facing downwardly from the step portion. A gate insulating layer 120 and a gate electrode 130 may be disposed within the gate trench GT.

The gate electrodes 130 may be respectively disposed within the gate trenches GT. The gate electrode 130 may be disposed on (e.g., directly thereon) the gate insulating layer 120 within the gate trench GT. The gate electrode 130 may overlap the drift layer 102, the well region 105, and the source region 107 in a horizontal direction, for example, the X direction. A lower surface of the gate electrode 130 may be located within the drift layer 102. For example, the lower surface of the gate electrode 130 may be located on a level (e.g., height in the Z direction) lower than that of a lower surface of the well region 105. An upper surface of the gate electrode 130 may be located on a level (e.g., height in the Z direction) lower than that of an upper surface of the source region 107. However, embodiments of the present inventive concept are not necessarily limited thereto. For example, in some example embodiments, a level of the upper surface of the gate electrode 130 may be located on the same level as or on a level higher than the upper surface of the source region 107.

A lower surface of the gate electrode 130 may have a first width W1 (e.g., as measured in the X direction) and an upper surface of the gate electrode 130 may have a second width W2 (e.g., as measured in the X direction) greater than the first width W1. For example, the gate electrode 130 may have a maximum width on the upper surface. The gate electrode 130 may have a shape corresponding to the shape of the gate trench GT, and a side surface of the gate electrode 130 may have a step portion BR. The step portion BR may face the well region 105 with the gate insulating layer 120 interposed therebetween. The step portion BR may be spaced apart from the source region 107, and may be located on a level lower than that of the lower surface of the source region 107. In an embodiment, the gate electrode 130 may have a shape which is horizontally symmetrical, and a shape which is vertically asymmetrical.

In an embodiment, the gate electrode 130 may have a dual gate structure including a first region G1 and a second region G2 on the first region G1 (e.g., disposed directly thereon in the Z direction). The first region G1 and the second region G2 may be disposed vertically based on the step portion BR. For example, in an embodiment the first region G1 may have a substantially constant first width W1. However, embodiments of the present inventive concept are not necessarily limited thereto. For example, a lower surface of the second region G2, in direct contact with the first region G1 may also have the first width W 1, and other regions thereof may have a width, greater than the first width W1. In an embodiment, the second region G2 may have a width greater than the maximum width of the first region G1. In the Z direction, the length of the first region G1 may be greater than the length of the second region G2. However, embodiments of the present inventive concept are not necessarily limited thereto and the relative lengths of the first region G1 and the second region G2 may vary in example embodiments. The gate electrode 130 may have a recessed portion DP in the upper surface which is recessed downwardly towards the substrate 101. However, embodiments of the present inventive concept are not necessarily limited thereto and in example embodiments, the presence/absence, shape, depth, and the like of the recessed portion DP may vary.

In an embodiment, the gate electrode 130 may include a conductive material, for example, a semiconductor material such as doped polycrystalline silicon, a metal nitride such as titanium nitride (TiN), tantalum nitride (TaN), or tungsten nitride (WN), and/or a metal material such as aluminum (Al), tungsten (W), molybdenum (Mo), or the like. Depending on example embodiments, the gate electrode 130 may be composed of two or more layers.

As illustrated in FIG. 1B, the well region 105 may include a region which has a bent shape while facing the gate electrode 130 and the gate insulating layer 120. The region may correspond to the step portion BR. A side surface of the well region 105 facing the gate electrode 130 may include a curved first surface and a second surface that has a bent shape and is extended from the first surface. The first surface may have a shape, which is not linear, for example, a non-linear shape, and the second surface may extend in a discontinuous form from the first surface. The first surface may be a curved surface and may extend along the source region 107 and the well region 105, and the second surface may be a straight surface extending downwardly through the well region 105 (e.g., in the Z direction). In an embodiment, an angle between the first surface and the second surface may be an obtuse angle.

When the power semiconductor device 100 is operated, a channel region CR of a transistor may be formed in the well region 105 adjacent to the gate electrode 130 and facing the gate electrode 130. For example, in an embodiment, the channel region CR may extend from the source region 107 to the drift layer 102, such as an upper surface of the drift layer 102. The channel region CR may include a region including the side surface or adjacent to the side surface of the well region 105. The channel region CR may face the gate electrode 130 with the gate insulating layer 120 interposed therebetween. The channel region CR is a partial region of the well region 105, and may extend downwardly (e.g., in the Z direction) from the source region 107 along the drift layer 102. The channel region CR may have a bent shape along the shape of the gate electrode 130 and the gate insulating layer 120 and extends downwardly. The channel region CR may extend in a non-linear shape, and a surface of the channel region CR facing the gate electrode 130 may have at least two surfaces. The channel region CR may overlap the gate electrode 130 horizontally (e.g., in the X direction). For example, in an embodiment a length of the channel region CR may be in a range from about 0.2 µm to about 0.8 µm (e.g. from 0.2 µm to 0.8 µm).

In an embodiment, since the gate electrode 130 has a bent shape with a step portion BR between the first region G1 and the second region G2, a portion of the channel region CR may be affected by both the first region G1 and the second region G2. The portion of the channel region CR may overlap the first region G1 in the horizontal direction and may overlap the second region G2 in the vertical direction. For example, the portion of the channel region CR may be affected by two surfaces of the gate electrode 130 at the same time. Accordingly, the threshold voltage may be reduced, thereby increasing mobility, and the occurrence of leakage current before turn-on may be reduced. Therefore, even when deterioration in mobility occurs since the power semiconductor device 100 is based on SiC, the electrical characteristics of the power semiconductor device 100 may be secured.

Gate insulating layers 120 may be respectively disposed within the gate trenches GT. The gate insulating layer 120 may be disposed on the side surface and lower surface of the gate electrode 130. In an embodiment, the gate insulating layer 120 may be disposed between the source region 107 and the gate electrode 130, the well region 105 and the gate electrode 130, and the drift layer 102 and the gate electrode 130.

In an embodiment, the gate insulating layer 120 may have a non-uniform thickness. As shown in FIG. 1B, the gate insulating layer 120 may have a first thickness T1 (e.g., as measured in the Z direction) on a bottom surface of the gate trench GT and a second thickness T2 (e.g., as measured in the X direction) that is less than the first thickness T1 on a sidewall of the gate trench GT. In this context, the thickness of the gate insulating layer 120 at a particular point may be measured along a direction perpendicular to an inner surface and/or an outer surface of the gate insulating layer 120 at that point. In a lower region of the gate trench GT, the gate insulating layer 120 may have a lower surface which has a downwardly convex shape along the gate trench GT and an upper surface, which is substantially flat facing the gate electrode 130. Below the gate electrode 130, the gate insulating layer 120 may include a region of which a thickness in the Z direction gradually decreases toward both lateral sides from a center of the gate trench GT. The gate insulating layer 120 may have a relatively large thickness on the bottom surface of the gate trench GT, thereby mitigating the electric field formed in the drift layer 102 by the gate electrode 130 to prevent the breakdown of the gate insulating layer 120.

In an embodiment, the gate insulating layer 120 may include an oxide, a nitride, or a high-x material. The high-κ material may mean a dielectric material having a higher dielectric constant than a silicon oxide (SiO₂) film. In an embodiment, the high-κ material may be, for example, any one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), or praseodymium oxide (Pr₂O₃).

The dielectric layers 140 may cover the gate electrodes 130, and may be disposed to expose a portion of each of the source regions 107 and the well contact regions 109. For example, in an embodiment, the dielectric layers 140 may overlap an entirety of upper surfaces of the gate electrodes 130 (e.g., in the Z direction) and may overlap only portions of the upper surfaces of the source regions 107. The dielectric layer 140 may fill the gate trench GT and cover the upper surface of the gate electrode 130 and the upper surface of the gate insulating layer 120. In an embodiment, the dielectric layer 140 may include an insulating material, and may include at least one of silicon oxide, silicon nitride, and silicon oxynitride. In an embodiment, the dielectric layers 140 may each have a recessed portion overlapping (e.g., in the Z direction) the recessed portion DP of corresponding the gate electrode 130 upon which they are disposed.

The source electrode 150 may be disposed on (e.g., disposed directly thereon) the dielectric layers 140 and may be electrically connected to the source regions 107 and the well contact regions 109. In an embodiment, the source electrode 150 may include a metal-semiconductor compound layer 152 and a conductive layer 154. In an embodiment, the metal-semiconductor compound layer 152 may include a metal element and a semiconductor element, for example, at least one of TiSi, CoSi, MoSi, LaSi, NiSi, TaSi, or Wsi. The conductive layer 154 may include at least one metal material, for example, nickel (Ni), aluminum (Al), titanium (Ti), silver (Ag), vanadium (V), tungsten (W), cobalt (Co), molybdenum (Mo), copper (Cu), and ruthenium (Ru).

The drain electrode 160 may be disposed on (e.g., disposed directly thereon in the Z direction) the lower surface of the substrate 101 and may be electrically connected to the substrate 101. In an embodiment, the drain electrode 160 may include at least one of a metal material, for example, nickel (Ni), aluminum (Al), titanium (Ti), silver (Ag), vanadium (V), and tungsten (W). In some example embodiments, the drain electrode 160 may also include a metal-semiconductor compound layer and a conductive layer, similar to the source electrode 150.

In the description of the following embodiments, descriptions overlapping with those described above with reference to FIGS. 1A and 1B may be omitted for economy of explanation.

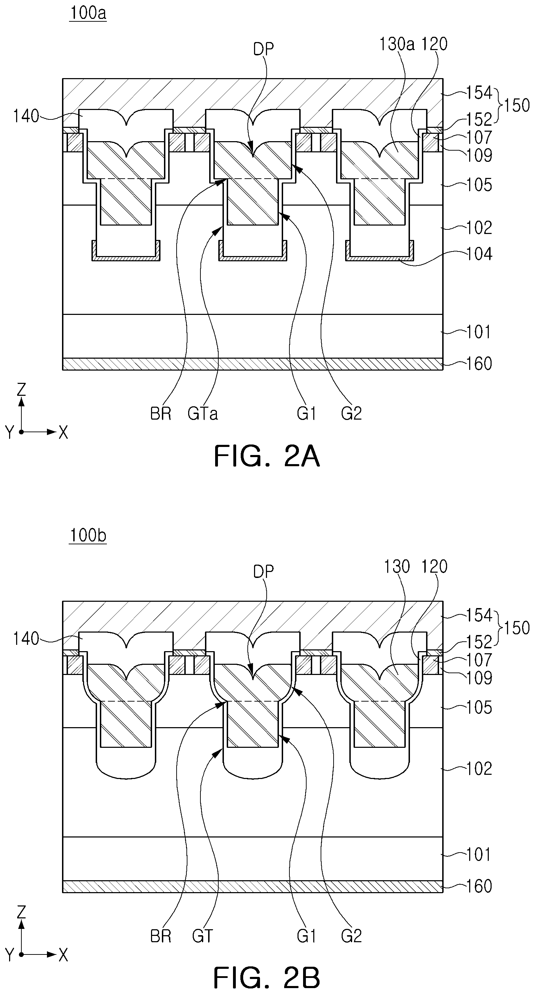

FIGS. 2A to 2C are cross-sectional views illustrating power semiconductor devices according to example embodiments. FIGS. 2A to 2C respectively illustrate a region corresponding to the cross-section in FIG. 1A.

Referring to FIG. 2A, in the power semiconductor device 100a according to an embodiment, the gate trench GTa and the gate electrode 130a may have an angular shape without a bent shape. For example, in an embodiment the step portion BR may be bent at a right angle or an angle close to the right angle. Accordingly, in the gate electrode 130, the second region G2 may have side surfaces extending substantially in a straight line and may have a substantially constant width. A side surface of the well region 105 facing the gate electrode 130 may include a first surface extending from above, a second surface connected to the first surface and extending horizontally, and a third surface extending vertically downwardly from the second surface. As described above, in example embodiments, the specific shapes of the gate trench GTa and the gate electrode 130a may be changed in various manners.

Referring to FIG. 2B, in an embodiment the power semiconductor device 100b may not include the field relief region 104 of FIG. 1A. Accordingly, the gate insulating layer 120 may directly contact the drift layer 102 at a lower end of the gate trench GT. However, even in this embodiment, an electric field formed in the drift layer 102 may be relieved due to the non-uniform thickness of the gate insulating layer 120.

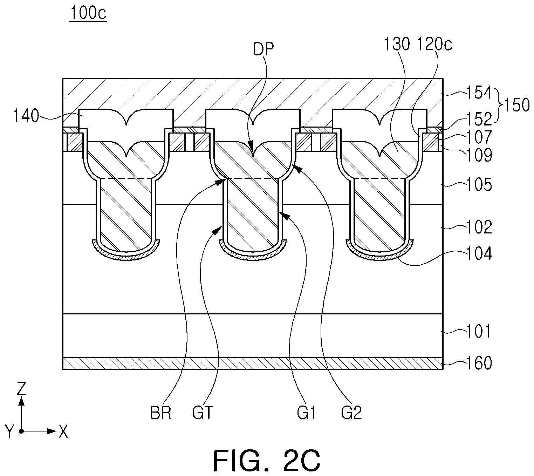

Referring to FIG. 2C, in the power semiconductor device 100c, the gate insulating layer 120c may have a substantially constant thickness. For example, a thickness of the lower surface of the gate insulating layer 120c (e.g., in the Z direction) may be substantially the same as the thickness of the remaining portion of the gate insulating layer 120c (e.g., in the X direction). The gate insulating layer 120c may extend conformally along the internal surface of the gate trench GT. However, even in this embodiment, an electric field formed in the drift layer 102 may be relieved by the field relief region 104.

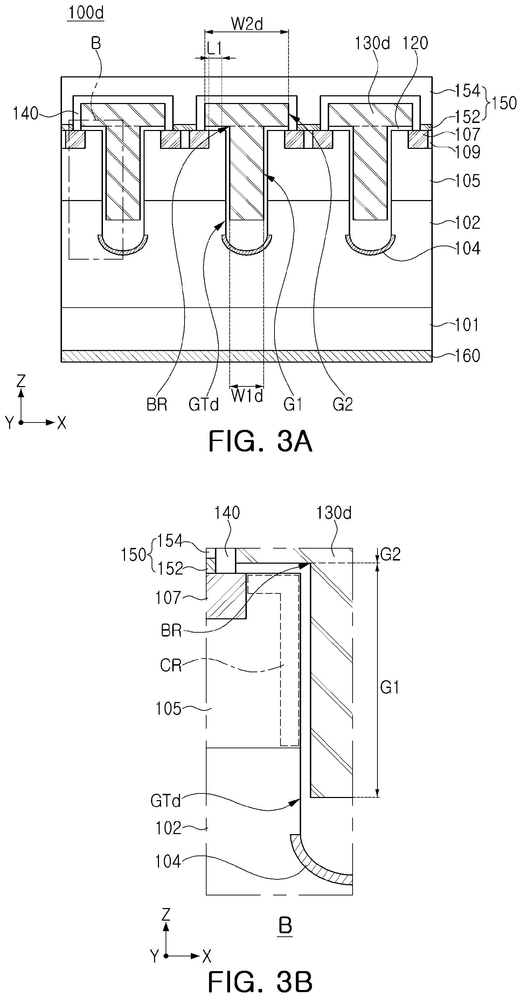

FIGS. 3A and 3B are cross-sectional views and partially enlarged views illustrating a power semiconductor device according to example embodiments. FIG. 3B illustrates an enlarged view of area 'A' in FIG. 3A.

Referring to FIGS. 3A and 3B, in a power semiconductor device 100d, the shape of a gate trench GTd and the shape of a gate electrode 130d may be different from those in embodiments of FIGS. 1A to 2C. The gate trench GTd may extend in a Z direction from an upper surface of the well region 105 to penetrate the well region 105. Accordingly, the gate trench GTd may not have a step portion.

The gate electrode 130d may extend from the upper surface of the well region 105 into the gate trench GTd. In the gate electrode 130d, a first region G1 may have a substantially constant first width W1d, and a second region G2 may have a substantially constant second width W2d, greater than the first width W1d. However, embodiments of the present inventive concept are not necessarily limited thereto. In a Z direction, a length of the first region G1 may be longer than a length of the second region G2. In an embodiment, the step portion BR of the gate electrode 130d may be located on a higher level than the upper surface of the source region 107 and the upper surface of the well region 105. In some example embodiments, the upper surface of the gate electrode 130d may have a recessed portion, which is recessed downwardly towards the substrate 101. In an embodiment, the upper surface of the gate electrode 130d is positioned at a higher level than a level of the upper surface of the source region 107.

The source regions 107 may be disposed to be horizontally spaced apart from the gate trench GTd by a first length L1. For example, in an embodiment the first length L1 may be in a range from about 20% to about 40% of the length of the channel region CR. However, the relative size of the first length L1 may vary in various example embodiments.

As illustrated in FIG. 3B, a surface of the well region 105 facing the gate electrode 130d may include a first surface corresponding to the upper surface and a second surface extending vertically from the first surface. The second surface may be a surface extending downwardly through the well region 105. In an embodiment, an angle between the first surface and the second surface may be a right angle or an angle close to the right angle.

When the power semiconductor device 100d is operated, a channel region CR of a transistor may be formed in a region of the well region 105 facing the gate electrode 130d. The channel region CR may be a region including the surface or adjacent to the surface. In an embodiment, the channel region CR may have an inverted 'L' shape. The channel region CR may overlap the gate electrode 130d both vertically (e.g., in the Z direction) and horizontally (e.g., in the X direction). At least a portion of the channel region CR may be affected by both the first region G1 and the second region G2. At least a portion of the channel region CR may overlap the first region G1 in the horizontal direction and the second region G2 in the vertical direction. For example, the portion of the channel region CR may be controlled by being affected by two surfaces of the gate electrode 130 at the same time. Accordingly, the threshold voltage is reduced, thereby increasing mobility, and the occurrence of leakage current before turn-on may be reduced. Accordingly, even when the mobility is reduced in the power semiconductor device 100d based on SiC, the electrical characteristics of the power semiconductor device 100d may be secured.

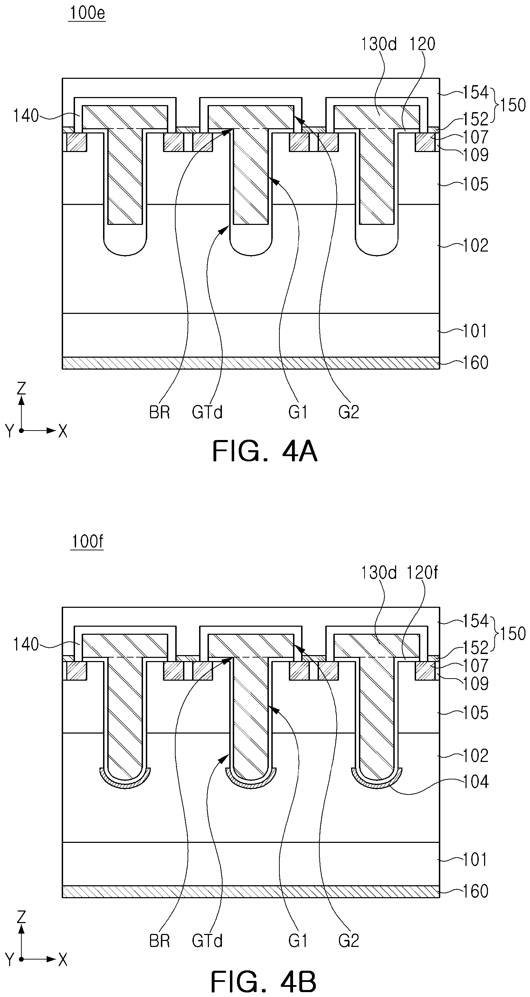

FIGS. 4A and 4B are cross-sectional views illustrating power semiconductor devices according to example embodiments. FIGS. 4A and 4B respectively illustrate regions corresponding to the cross-section in FIG. 3A.

Referring to FIG. 4A, a power semiconductor device 100e may not include the field relief region 104 of FIG. 3A. Accordingly, the gate insulating layer 120 may directly contact the drift layer 102 at the bottom of the gate trench GTd. However, even in this embodiment, an electric field formed in the drift layer 102 may be relieved due to a non-uniform thickness of the gate insulating layer 120.

Referring to FIG. 4B, in a power semiconductor device 100f, a gate insulating layer 120f may have a substantially constant thickness. The gate insulating layer 120f may conformally extend along an internal surface of the gate trench GTd. However, even in this embodiment, the electric field formed in the drift layer 102 can be relaxed by the field relief region 104.

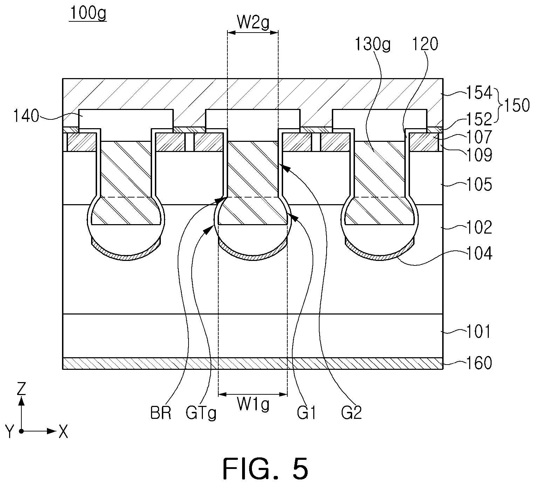

FIG. 5 is a cross-sectional view illustrating a power semiconductor device according to an example embodiment.

Referring to FIG. 5, in a power semiconductor device 100g according to an embodiment, a shape of a gate trench GTg and a shape of a gate electrode 130g may be different from those in embodiments of FIGS. 1A to 2C. In an embodiment, the gate trench GTg may have an upper region having a width that is narrower than a width of the lower region. The gate trench GT may have a substantially constant width from a step portion of the side wall upwardly, and may include a region in which a width thereof non-linearly increases and a region in which a width thereof non-linearly decreases downwardly from the step portion.

In the gate electrode 130g, for example, a first region G1 may have a circular cross-section or a cross-section similar to a circle, and a lower surface of the first region G1 may have a first width W1g, which is a maximum width. The second region G2 may have a substantially constant second width W2g. For example, the first region G1 may have widths that are both greater than or equal to the maximum width of the second region G2. In an embodiment, in a Z direction, a length of the first region G1 may be less than a length of the second region G2. However, embodiments of the present inventive concept are not necessarily limited thereto and the relative lengths of the first region G1 and the second region G2 may vary in various example embodiments. In example embodiments, the gate electrode 130g may have a recessed portion on the upper surface recessed downwardly toward the substrate 101.

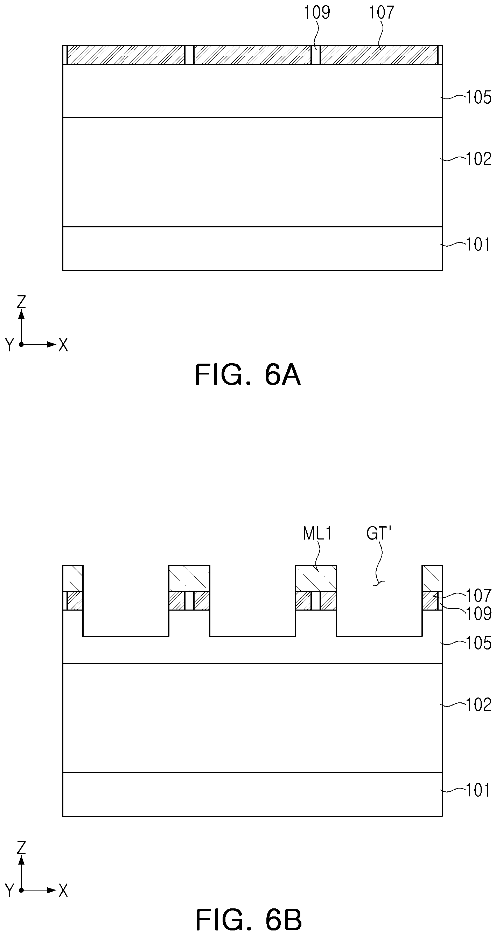

FIGS. 6A to 6H are diagrams illustrating a process sequence to explain a method of manufacturing a power semiconductor device according to example embodiments.

FIGS. 6A to 6H describe an example embodiment of a manufacturing method for manufacturing the power semiconductor device of FIG. 1A.

Referring to FIG. 6A, in an embodiment, a drift layer 102 may be formed on the substrate 101 (e.g., formed directly thereon), and a well region 105, source regions 107, and well contact regions 109 may be formed.

The substrate 101 may be provided as a SiC wafer, for example. In an embodiment, the drift layer 102 may be formed by epitaxial growth from the substrate 101. The drift layer 102 may be formed to include first conductivity-type impurities.

In an embodiment, the well region 105, the source regions 107, and the well contact regions 109 may be sequentially formed in the drift layer 102 by an ion implantation process. Second conductivity-type impurities may be implanted into the well region 105 and the well contact regions 109, and first conductivity-type impurities may be implanted into the source regions 107. In an embodiment, after the ion implantation process, an annealing process may be performed at a high temperature, for example, about 1600°C to about 1800°C (e.g. 1600°C to 1800°C).

Referring to FIG. 6B, preliminary gate trenches GT' may be formed by partially removing the source regions 107 and the well region 105.

In an embodiment, the preliminary gate trenches GT' may be formed by partially removing the source regions 107 and the well region 105 using a first mask layer ML1. For example, the first mask layer ML1 may be a hard mask layer. The preliminary gate trenches GT' may be formed to be spaced apart from each other in a horizontal direction, for example, an X direction. The preliminary gate trenches GT' may be formed to penetrate the source regions 107, and the well region 105 may be exposed through the bottom surface.

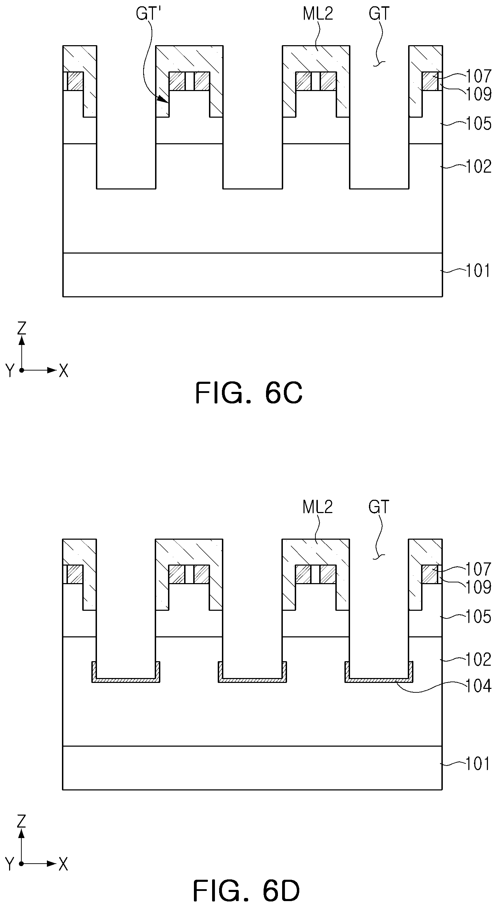

Referring to FIG. 6C, gate trenches GT may be formed by partially removing the well region 105 and the drift layer 102.

By partially exposing the preliminary gate trenches GT' using a second mask layer ML2 and partially removing the well region 105 and the drift layer 102, gate trenches GT may be formed. In an embodiment, the second mask layer ML2 may be, for example, a hard mask layer. The gate trenches GT may be formed to completely penetrate the well region 105, and the drift layer 102 may be exposed through the bottom surface.

Referring to FIG. 6D, field relief regions 104 may be formed along a portion of external surfaces of the gate trenches GT.

The field relief regions 104 may be formed to a predetermined thickness from the surface of the drift layer 102 exposed from the second mask layer ML2. In an embodiment, the field relief regions 104 may be formed by implanting second conductivity-type impurities through an ion implantation process. In example embodiments, the ranges and thicknesses of the field relief regions 104 may vary. However, embodiments of the present inventive concept are not necessarily limited thereto. For example, in some example embodiments, a process for forming the field relief regions 104 may be omitted.

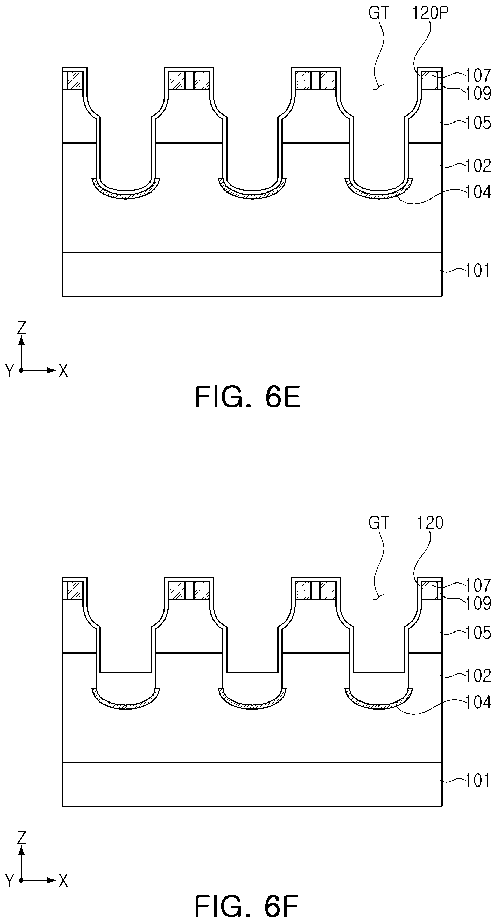

Referring to FIG. 6E, in an embodiment an annealing process may be performed and a preliminary gate insulating layer 120P may be formed on inner surfaces of the gate trenches GT.

In an embodiment, the second mask layer ML2 may first be removed and an annealing process may then be performed. In an embodiment, the annealing process may include, for example, a hydrogen (H₂) annealing process performed in a hydrogen (H₂) atmosphere and a high-temperature annealing process. By the hydrogen (H₂) annealing process, the gate trenches GT may be smoothed, so that an angle of the inner surfaces of the gate trenches GT may be relieved and the gate trenches GT may have a curved shape.

In an embodiment, the preliminary gate insulating layer 120P may be formed through, for example, an oxidation process, such as a thermal oxidation process. In some example embodiments, the preliminary gate insulating layer 120P may be formed by a deposition process.

Referring to FIG. 6F, a gate insulating layer 120 may be formed by further forming an insulating material on bottom surfaces of the gate trenches GT.

In an embodiment, the insulating material may be additionally formed only on the preliminary gate insulating layer 120P on the bottom surfaces of the gate trenches GT. In an embodiment, the insulating material may be formed, for example, through a spin-on glass (SOG) process or a high temperature oxide (HTO) process. However, embodiments of the present inventive concept are not necessarily limited thereto and in some example embodiments, the present process may be omitted.

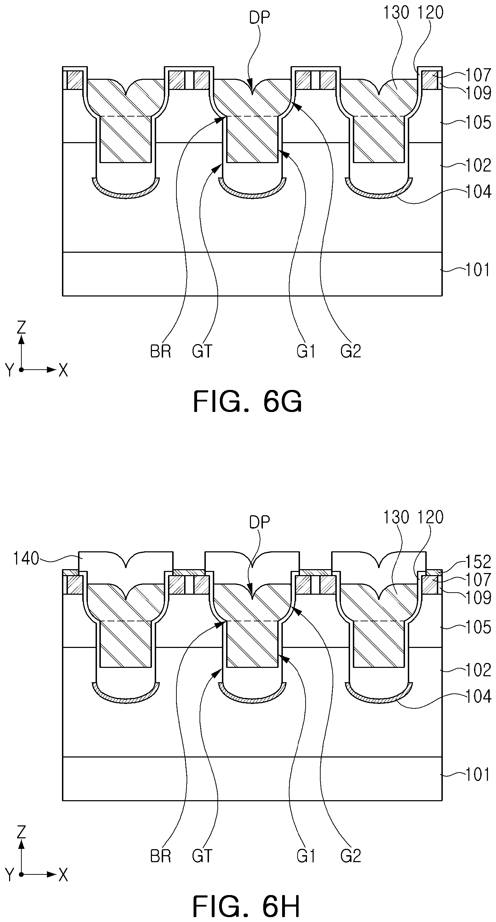

Referring to FIG. 6G, gate electrodes 130 may be formed on (e.g., formed directly thereon) the gate insulating layer 120.

In an embodiment, the gate electrodes 130 may be formed, for example, by depositing doped polycrystalline silicon and performing an etch-back process. The gate electrodes 130 may be formed to be located only within the gate trenches GT. In some example embodiments, in the present step, the gate insulating layer 120 may also be partially removed to be located only within the gate trenches GT. In an embodiment, the gate electrodes 130 may be formed to have step portions BR according to the shape of the gate trenches GT, and may have a dual gate structure. The gate electrodes 130 may have recessed portions DP in upper surfaces of the gate electrodes 130 depending on an aspect ratio of the gate trenches GT, deposition conditions of the gate structures 130, or the like. However, embodiments of the present inventive concept are not necessarily limited thereto and in some example embodiments, the upper surfaces of the gate electrodes 130 may be flat.

Referring to FIG. 6H, dielectric layers 140 and metal-semiconductor compound layers 152 covering the gate electrodes 130 may be formed.

In an embodiment, the dielectric layers 140 may be deposited on the entirety of the upper surface of a structure being manufactured, and then partially removed through an etching process to expose a portion of each of the source regions 107 and the well contact regions 109. For example, in an embodiment the dielectric layers 140 may be formed by being patterned together with the gate insulating layers 120. However, embodiments of the present inventive concept are not necessarily limited thereto and in some example embodiments, the gate insulating layers 120 may be patterned in a separate process. The dielectric layer 140 may be formed to cover an upper surface of the gate electrode 130 and an upper surface of the gate insulating layer 120 and expose a portion of an upper surface of the source region 107.

Metal-semiconductor compound layers 152 may be formed on the upper surfaces of the source regions 107 and the well contact regions 109. In an embodiment, the metal-semiconductor compound layers 152 may be formed, for example, through a silicidation process.

Next, referring to FIG. 1A, a conductive layer 154 may be formed on the metal-semiconductor compound layers 152, and a drain electrode 160 may be formed on a lower surface of the substrate 101.

The conductive layer 154 may be formed to cover the metal-semiconductor compound layers 152 and the dielectric layers 140, thereby forming a source electrode 150.

In an embodiment, a drain electrode 160 may then be formed by depositing a metal material on the lower surface of the substrate 101. In some example embodiments, the drain electrode 160 may be formed in another process step. As a result, the power semiconductor device 100 of FIG. 1A may be manufactured.

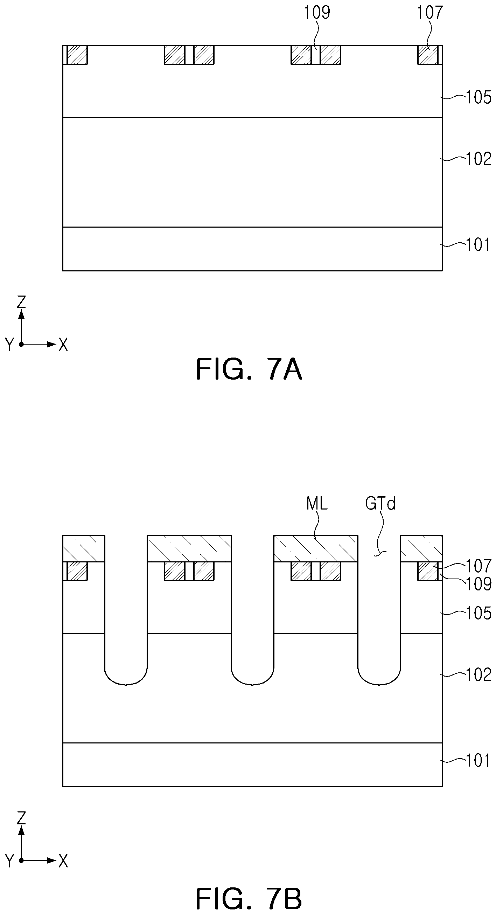

FIGS. 7A to 7G are diagrams illustrating a process sequence to explain a method of manufacturing a power semiconductor device according to example embodiments. FIGS. 7A to 7G describe an example embodiment of a manufacturing method for manufacturing the power semiconductor device of FIG. 3A.

Referring to FIG. 7A, in an embodiment a drift layer 102 may be formed on the substrate 101, and a well region 105, source regions 107, and well contact regions 109 may be formed. The present step may be performed in the same manner as described above with reference to FIG. 6A. However, in the present step, source regions 107 may be formed to be spaced apart from each other in a horizontal direction (e.g., the X direction).

Referring to FIG. 7B, gate trenches GTd may be formed by partially removing the well region 105 and the drift layer 102.

In an embodiment, the gate trenches GTd may be formed by partially exposing the well region 105 between the source regions 107 and partially removing the well region 105 and the drift layer 102 using a mask layer ML. In an embodiment, the mask layer ML may be, for example, a hard mask layer. The gate trenches GTd may be formed to be spaced apart from each other in a horizontal direction, for example, in an X direction. In an embodiment, the gate trenches GTd may be formed to completely penetrate the well region 105 (e.g., in the Z direction), and the drift layer 102 may be exposed through the bottom surface.

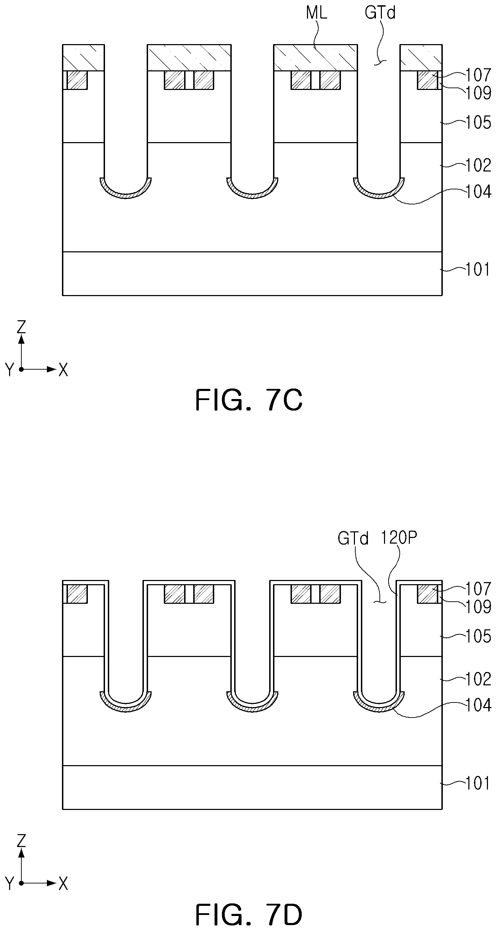

Referring to FIG. 7C, field relief regions 104 may be formed along a portion of external surfaces of the gate trenches GTd.

In an embodiment, the field relief regions 104 may be formed to have a predetermined thickness from a surface of the drift layer 102 exposed from the mask layer ML. The field relief regions 104 may be formed by implanting second conductivity- type impurities through an ion implantation process. In example embodiments, levels of upper ends of the field relief regions 104 can be varied.

Referring to FIG. 7D, in an embodiment an annealing process may be performed and a preliminary gate insulating layer 120P may be formed on inner surfaces of the gate trenches GTd.

In an embodiment, the mask layer ML may first be removed and an annealing process may be performed. The annealing process may be performed at high temperature. The preliminary gate insulating layer 120P may be formed in the same manner as described above with reference to FIG. 6E.

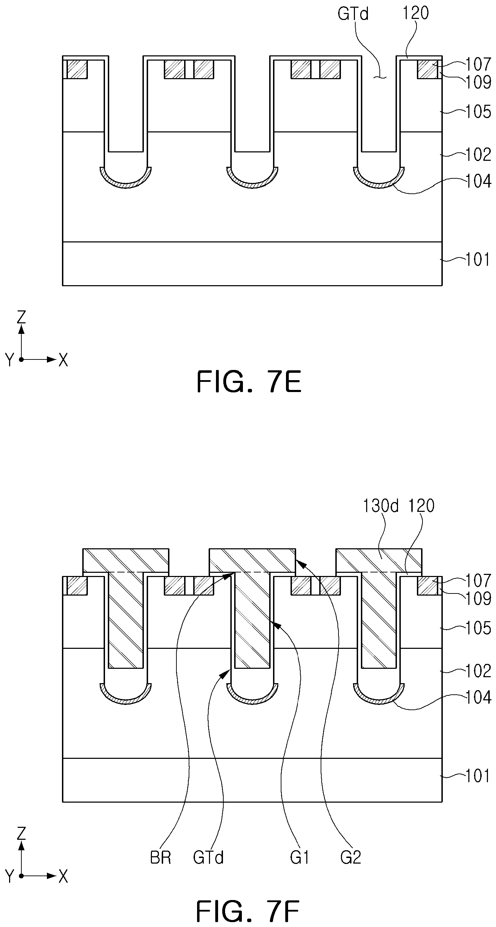

Referring to FIG. 7E, a gate insulating layer 120 may be formed by further forming an insulating material on the bottom surfaces of the gate trenches GTd. The gate insulating layer 120 may be formed in the same manner as described above with reference to FIG. 6F.

Referring to FIG. 7F, gate electrodes 130d may be formed on the gate insulating layers 120.

The gate electrodes 130d may be formed, for example, by depositing doped polycrystalline silicon and performing a patterning process together with the gate insulating layer 120. The gate electrodes 130d may be formed to have step portions BR depending on the shape of the gate trenches GTd. For example, in an embodiment, the gate electrodes 130d may have a'T' shape in a cross-sectional view.

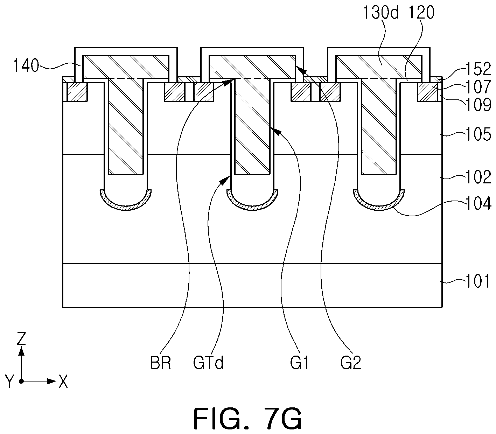

Referring to FIG. 7G, dielectric layers 140 and metal-semiconductor compound layers 152 covering the gate electrodes 130d may be formed. The present step may be performed in the same manner as described above with reference to FIG. 6H.

In an embodiment, referring to FIG. 3A, a conductive layer 154 may then be formed and a drain electrode 160 may be formed on a lower surface of the substrate 101. As a result, the power semiconductor device 100d of FIG. 3A may be manufactured.

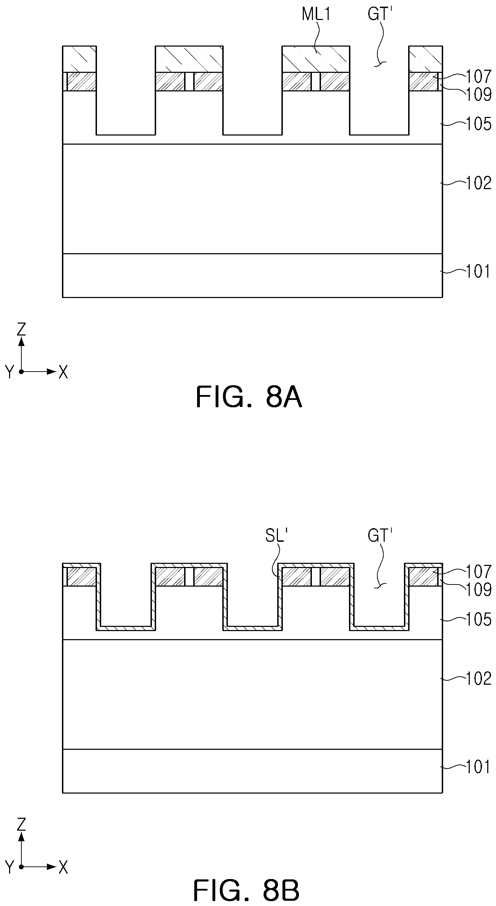

FIGS. 8A to 8I are diagrams illustrating a process sequence to explain a method of manufacturing a power semiconductor device according to example embodiments. FIGS. 8A to 8I describe an embodiment of a manufacturing method for manufacturing the power semiconductor device of FIG. 5.

Referring to FIG. 8A, in an embodiment, preliminary gate trenches GT' may be formed by forming a drift layer 102 on the substrate, and forming a well region 105, source regions 107, and well contact regions 109 and then partially removing the source regions 107 and the well region 105. The present step may be performed in the same manner as the process described above with reference to FIGS. 6A and 6B.

Referring to FIG. 8B, a preliminary spacer layer SL' may be formed on inner surfaces of the preliminary gate trenches GT' and upper surfaces of the source regions 107. In an embodiment, the preliminary spacer layer SL' may include, for example, silicon nitride. The preliminary spacer layer SL' may be formed by being conformally deposited on the entire structure being manufactured.

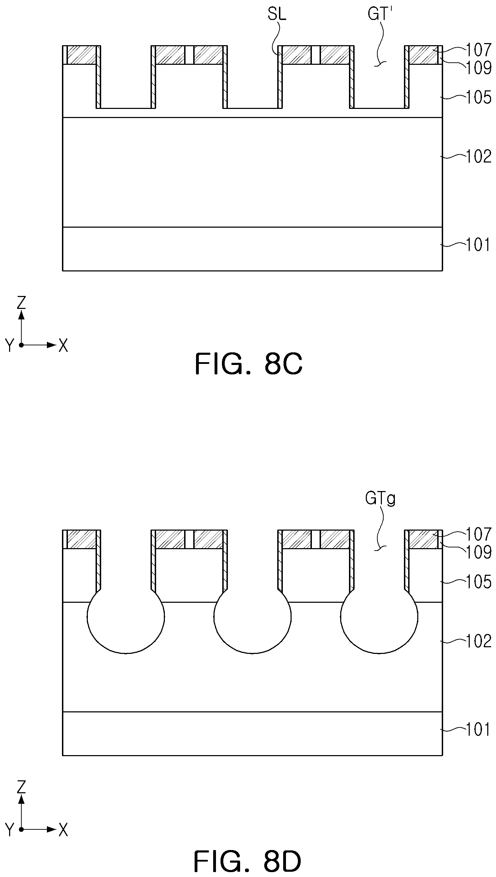

Referring to FIG. 8C, spacers SL may be formed by partially removing the preliminary spacer layer SL'. Regions of the preliminary spacer layers SL' which extend horizontally may be selectively removed, so that the spaces SL may remain only on inner sidewalls of the preliminary gate trenches GT'.

Referring to FIG. 8D, gate trenches GTg may be formed by partially removing the well region 105 and drift layer 102 exposed through the preliminary gate trenches GT' and spacers SL.

In an embodiment, the well region 105 and the drift layer 102 may be removed by, for example, an isotropic etching process. Accordingly, a region etched in the present step may have a circular, oval, or similar shape in the cross-section thereof. For example, in an embodiment, each of the gate trenches GTg may have a bulb shape.

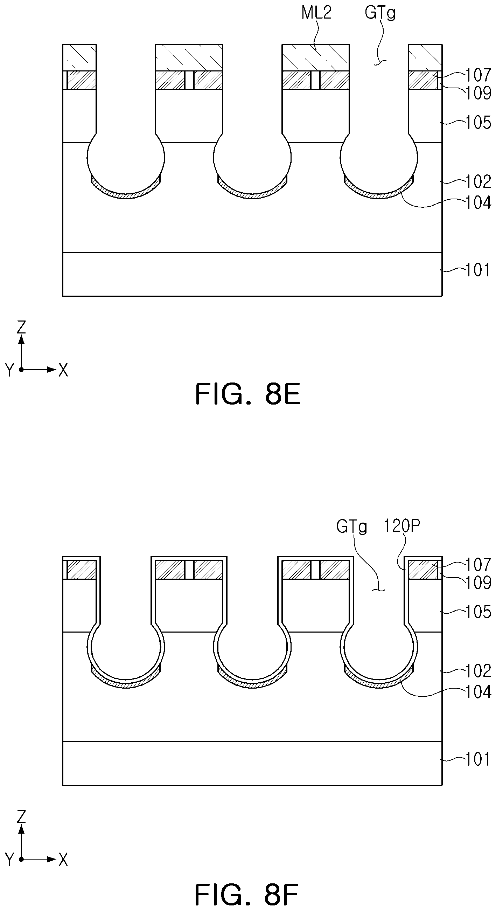

Referring to FIG. 8E, in an embodiment, field relief regions 104 may be formed along a portion of external surfaces of the gate trenches GTg. The field relief regions 104 may be formed to a predetermined thickness from a surface of the drift layer 102 in a region adjacent to bottom surfaces of the gate trenches GTg exposed through a second mask layer ML2.

Referring to FIG. 8F, an annealing process may be performed and a preliminary gate insulating layer 120P may be formed on inner surfaces of the gate trenches GTg. In an embodiment, the second mask layer ML2 may be first removed and an annealing process may be performed. The annealing process may be performed at high temperature. The preliminary gate insulating layer 120P may be formed in the same manner as described above with reference to FIG. 6E.

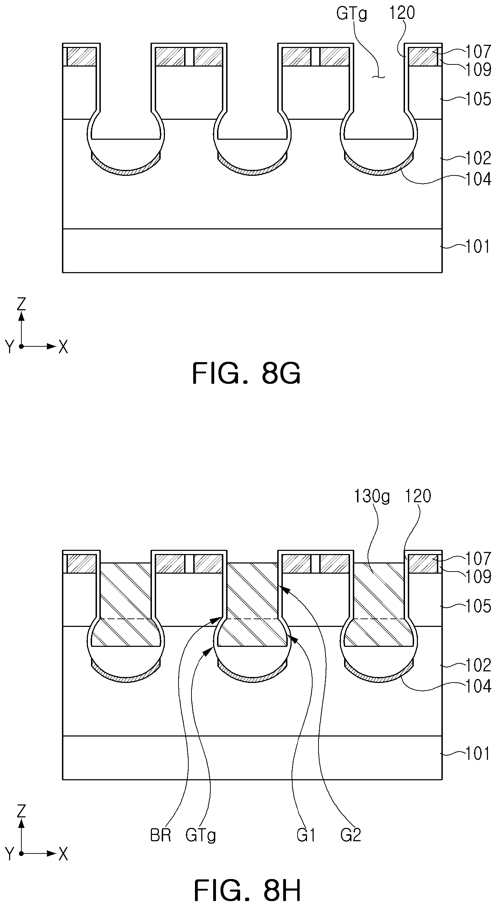

Referring to FIG. 8G, the gate insulating layer 120 may be formed by further forming an insulating material on the bottom surfaces of the gate trenches GTg. The present step may be formed in the same manner as described above with reference to FIG. 6F.

Referring to FIG. 8H, gate electrodes 130g may be formed on the gate insulating layer 120. In an embodiment, the gate electrodes 130g may be formed, for example, by depositing doped polycrystalline silicon and performing an etch-back process. The gate electrodes 130g may be formed to have step portions BR depending on the shape of the gate trenches GTg. In some example embodiments, in the present step, the gate insulating layer 120 may also be partially removed to be located only within the gate trenches GTg.

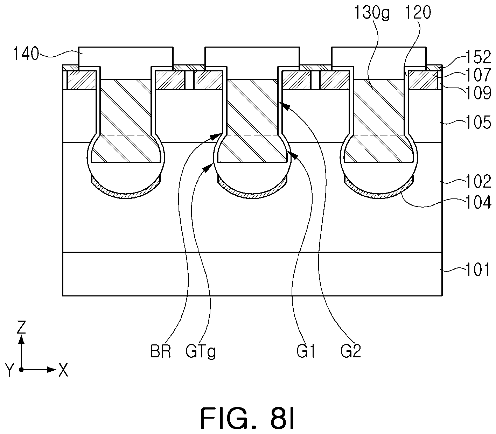

Referring to FIG. 8I, dielectric layers 140 and metal-semiconductor compound layers 152 covering the gate electrodes 130g may be formed. The present step may be performed in the same manner as described above with reference to FIG. 6H.

In an embodiment, referring to FIG. 5, a conductive layer 154 may then be formed and a drain electrode 160 may be formed on the lower surface of the substrate 101. As a result, the power semiconductor device 100g of FIG. 5 may be manufactured.

As set forth above, by having a gate electrode to have a step portion so that a channel region is affected through two or more surfaces of the gate electrode, a power semiconductor device having increased electrical characteristics may be provided.

Embodiments are set out in the following clauses:
Clause 1. A power semiconductor device, comprising:
   a substrate having a first conductivity-type;
   a drift layer on the substrate, the drift layer having the first conductivity-type;
   a well region on the drift layer, the well region having a second conductivity-type;
   a source region on the well region, the source region having the first conductivity-type;
   a gate electrode in a gate trench penetrating the source region and the well region;
   a gate insulating layer between the gate electrode and the well region;
   a dielectric layer on the gate electrode; and
   a drain electrode on a lower surface of the substrate,
   wherein a lower surface of the gate electrode has a first width, an upper surface of the gate electrode has a second width that is greater than the first width and a side surface of the gate electrode has a step portion where a width of the gate electrode changes; and
   the step portion is positioned at a level lower than a level of a lower surface of the source region.
Clause 2. The power semiconductor device of Clause 1, wherein a surface of the well region facing the gate electrode has a bent shape and comprises a first surface and a second surface extending from the first surface.
Clause 3. The power semiconductor device of Clause 2, wherein:
   the first surface is a curved surface extending along the source region and the well region; and
   the second surface extends downwardly through the well region.
Clause 4. The power semiconductor device of Clause 2, wherein:
   the first surface is an upper surface of the well region; and
   the second surface is a lower surface that extends downwardly through the well region.
Clause 5. The power semiconductor device of any of Clauses 2-4, wherein an angle between the first surface and the second surface is a right angle or an obtuse angle.
Clause 6. The power semiconductor device of any preceding Clause, wherein the lower surface of the gate electrode is positioned at a level lower than a level of a lower surface of the well region.
Clause 7. The power semiconductor device of any preceding Clause, wherein the gate insulating layer has a first thickness on a bottom surface of the gate trench and a second thickness on a sidewall of the gate trench, the second thickness is less than the first thickness.
Clause 8. The power semiconductor device of any preceding Clause, wherein the upper surface of the gate electrode is positioned at a same level or a lower level than an upper surface of the source region.
Clause 9. The power semiconductor device of any of Clauses 1-7, wherein the upper surface of the gate electrode is positioned at a level higher than a level of an upper surface of the source region.
Clause 10. The power semiconductor device of any preceding Clause, wherein the gate electrode is spaced apart from the source region in a horizontal direction by the well region and the gate insulating layer.
Clause 11. The power semiconductor device of any preceding Clause, further comprising:
   a source electrode on the dielectric layer, the source electrode is electrically connected to the source region.
Clause 12. The power semiconductor device of any preceding Clause, wherein the substrate, the drift layer, and the well region comprise SiC.
Clause 13. The power semiconductor device of any preceding Clause, further comprising:
   a field relief region between the gate insulating layer and the drift layer, the field relief region having the second conductivity-type.
Clause 14. A power semiconductor device, comprising:
   a substrate having a first conductivity-type;
   a drift layer on the substrate, the drift layer having the first conductivity-type;
   a well region on the drift layer, the well region having a second conductivity-type;
   a source region on the well region, the source region having the first conductivity-type;
   a gate electrode in a gate trench penetrating the source region and the well region;
   a gate insulating layer between the gate electrode and the well region; and
   a drain electrode on a lower surface of the substrate,
   wherein the gate electrode includes a first region having a first width that is a maximum width of the first region, and a second region on the first region, the second region having a second width greater than the first width,
   the well region includes a channel region adjacent to the gate electrode, and
   the channel region includes a region overlapping the first region in a horizontal direction and overlapping the second region in a vertical direction.
Clause 15. The power semiconductor device of Clause 14, wherein the channel region has a bent shape and extends along the gate electrode.
Clause 16. The power semiconductor device of Clause 14 or Clause 15, wherein the channel region extends from the source region to the drift layer.
Clause 17. The power semiconductor device of any of Clauses 14-16, wherein a length of the first region is greater than a length of the second region in the vertical direction.
Clause 18. The power semiconductor device of any of Clauses 14-17, wherein the gate electrode has a recessed portion on an upper surface, the recessed portion is recessed towards the substrate.
Clause 19. A power semiconductor device, comprising:
   a substrate having a first conductivity-type;
   a drift layer on the substrate, the drift layer having the first conductivity-type;
   a well region on the drift layer, the well region having a second conductivity-type;
   a source region on the well region, the source region having the first conductivity-type;
   a gate electrode in a gate trench penetrating the source region and the well region;
   a gate insulating layer covering an internal surface of the gate trench;
   a field relief region covering a portion of an external surface of the gate insulating layer, the field relief region having the second conductivity-type; and
   a drain electrode on a lower surface of the substrate,
   wherein an upper surface of the gate electrode has a maximum width and the gate electrode has a vertically asymmetrical shape, and
   the well region includes a region facing the gate electrode that has a bent shape.
Clause 20. The power semiconductor device of Clause 19, wherein a first thickness of the gate insulating layer on a bottom surface of the gate trench is different from a second thickness of the gate insulating layer on a sidewall of the gate trench.

Various advantages and effects of embodiments of the present inventive concept are not limited to the above-described content.

While example embodiments have been illustrated and described above, it will be apparent to those skilled in the art that modifications and variations could be made without departing from the scope of the present inventive concept.

## Claims

1. A power semiconductor device, comprising:
a substrate having a first conductivity-type;
a drift layer on the substrate, the drift layer having the first conductivity-type;
a well region on the drift layer, the well region having a second conductivity-type;
a source region on the well region, the source region having the first conductivity-type;
a gate electrode in a gate trench penetrating the source region and the well region;
a gate insulating layer between the gate electrode and the well region; and
a drain electrode on a lower surface of the substrate,
wherein the gate electrode includes a first region having a first width that is a maximum width of the first region, and a second region on the first region, the second region having a second width greater than the first width,
the well region includes a channel region adjacent to the gate electrode, and
the channel region includes a region overlapping the first region in a horizontal direction and overlapping the second region in a vertical direction.

2. The power semiconductor device of claim 1, wherein a surface of the well region facing the gate electrode has a bent shape and comprises a first surface and a second surface extending from the first surface.

3. The power semiconductor device of claim 2, wherein:
the first surface is a curved surface extending along the source region and the well region; and
the second surface extends downwardly through the well region.

4. The power semiconductor device of claim 2, wherein:
the first surface is an upper surface of the well region; and
the second surface extends downwardly through the well region.

5. The power semiconductor device of any of claims 2-4, wherein an angle between the first surface and the second surface is a right angle or an obtuse angle.

6. The power semiconductor device of any preceding claim, wherein a lower surface of the gate electrode is positioned at a level lower than a level of a lower surface of the well region.

7. The power semiconductor device of any preceding claim, wherein the gate insulating layer has a first thickness on a bottom surface of the gate trench and a second thickness on a sidewall of the gate trench, the second thickness is less than the first thickness.

8. The power semiconductor device of any preceding claim, wherein an upper surface of the gate electrode is positioned at a same level or a lower level than an upper surface of the source region.

9. The power semiconductor device of any of claims 1-7, wherein an upper surface of the gate electrode is positioned at a level higher than a level of an upper surface of the source region.

10. The power semiconductor device of any preceding claim, wherein the gate electrode is spaced apart from the source region in a horizontal direction by the well region and the gate insulating layer.

11. The power semiconductor device of any preceding claim, further comprising:
a dielectric layer on the gate electrode; and
a source electrode on the dielectric layer, the source electrode being electrically connected to the source region.

12. The power semiconductor device of any preceding claim, wherein the substrate, the drift layer, and the well region comprise silicon carbide.

13. The power semiconductor device of any preceding claim, further comprising:
a field relief region between the gate insulating layer and the drift layer, the field relief region having the second conductivity-type.

14. The power semiconductor device of any preceding claim, wherein:
a side surface of the gate electrode has a step portion where a width of the gate electrode changes; and
the step portion is positioned at a level lower than a level of a lower surface of the source region.

15. The power semiconductor device of any preceding claim, wherein the channel region has a bent shape and extends along the gate electrode.
